# EUROPÄISCHE PATENTSCHRIFT

(11) **EP 1 238 120 B1**
(45) Veröffentlichungstag und Bekanntmachung des Hinweises auf die Patenterteilung: **17.03.2004**
(21) Anmeldenummer: 00990648.8
(22) Anmeldetag: 05.12.2000
(51) Int. Cl.: C23C 14/54, H01J 37/34

(54) **VORRICHTUNG UND VERFAHREN ZUR BESCHICHTUNG VON GEGENSTÄNDEN BEI HOHER TEMPERATUR**
DEVICE AND METHOD FOR COATING OBJECTS AT A HIGH TEMPERATURE
DISPOSITIF ET PROCEDE POUR LE REVETEMENT D'OBJETS A HAUTE TEMPERATURE

(30) Priorität: 06.12.1999 DE 19958643
(43) Veröffentlichungstag der Anmeldung: 11.09.2002
(73) Patentinhaber: Fraunhofer-Gesellschaft zur Förderung der angewandten Forschung e.V., 80686 München (DE)
(72) Erfinder: JUNG, Thomas, 38173 Hötzum (DE)
(74) Vertreter: Pfenning, Meinig & Partner
(86) Internationale Anmeldenummer: PCT/EP2000/012213
(87) Internationale Veröffentlichungsnummer: WO 2001/040534

(56) Entgegenhaltungen:
- DE-C- 19 632 410
- US-A- 3 294 669
- US-A- 4 224 897
- PATENT ABSTRACTS OF JAPAN vol. 013, no. 561 (E-859), 13. Dezember 1989 (1989-12-13) & JP 01 232710 A (YASKAWA ELECTRIC MFG CO LTD), 18. September 1989 (1989-09-18)
- DATABASE WPI Section Ch, Week 198030 Derwent Publications Ltd., London, GB; Class L02, AN 1980-52309C XP002166589 & JP 55 076066 A (MATSUSHITA ELEC IND CO LTD), 7. Juni 1980 (1980-06-07)

## Beschreibung

Die vorliegende Erfindung betrifft eine Vorrichtung und ein Verfahren zur Beschichtung eines Gegenstandes bei hoher Temperatur. Derartige Verfahren werden zur Beschichtung von Gegenständen insbesondere von Gasturbinenschaufeln beispielsweise mit Wärmedämmschichten, Korrosionsschutzschichten und/oder Hochtemperatursupraleiterschichten angewandt.

Zur Beschichtung von Gegenständen mit dünnen Schichten werden heutzutage plasmagestützte VakuumBeschichtungsverfahren verwendet. Hierzu gehört beispielsweise auch das Kathodenzerstäuben, das zur Gruppe der PVD-Verfahren zählt und aufgrund seiner Vorzüge, insbesondere im Vergleich zu dem technisch älteren thermischen Aufdampfen, mittlerweile eine sehr breite Anwendung gefunden hat.

Nach dem Stand der Technik werden in den meisten Fällen die Beschichtungen eines Substrates bei Raumtemperatur oder nur gering erhöhter Temperatur durchgeführt. Es gibt jedoch Anwendungsbereiche, bei denen zur Ausbildung der gewünschten Schichtstruktur die Temperatur des zu beschichtenden Gegenstandes (Substrat) während der Beschichtung sehr hoch sein muß, beispielsweise 700 °C bis 1100 °C. Dies ist beispielsweise der Fall bei der Herstellung von Hochtemperatursupraleiterschichten oder Korrosionsschutzund Wärmedämmschichten für Gasturbinenbauteile, insbesondere Turbinenschaufeln.

Zur Beschichtung von Substraten bei hoher Temperatur sind verschiedene Vorrichtungen bekannt. Aus Müller et al., Praktische Oberflächentechnik, Vieweg & Sohn Verlagsgesellschaft, Braunschweig, 1995, Seite 419, ist beispielsweise eine Magnetronsputterquelle bekannt, und aus WO 98/13531 ist eine Gasflußsputterquelle bekannt, bei denen die hohe Temperatur des Substrates mittels eines elektrischen Widerstandheizers erzeugt wird. Dieser Heizer ist vorzugsweise auf der der Sputterquelle abgewandten Seite des Substrates angebracht, um die von ihm erzeugte Wärme mittels Wärmeleitung bzw. Wärmestrahlung auf das Substrat rückwärtig zu übertragen.

Bei beiden, in diesen Druckschriften dargestellten Sputterquellen handelt es sich um Hochratesputterquellen, die bisher auch bei hoher Substrattemperatur grundsätzlich mit möglichst niedriger Targettemperatur betrieben werden. Dies ist beispielsweise in Kienel G. et al., Vakuumbeschichtung, VDI Verlag Düsseldorf 1995, Band 2 Seite 160 bis 181, beschrieben. Daher wird bei diesen herkömmlichen Hochratesputterquellen das Target gekühlt. Der Stand der Technik geht daher gewöhnlich selbstverständlich von einer Wasserkühlung des Targets aus.

Die in den oben genannten Dokumenten beschriebenen Vorrichtungen besitzen einige gravierende Nachteile. Denn aufgrund der sehr schnell mit der Substrattemperatur wachsenden Wärmeabstrahlung, die proportional zur vierten Potenz der absoluten Temperatur ist, kommt es zu beträchtlichen Energieverlusten durch Abstrahlung des Substrates zu den Wänden der Vakuumkammer und zu der Sputterquelle. Aus diesem Grund muß der Heizer für eine sehr große Leistung ausgelegt werden und verbraucht dementsprechend viel Energie. Andererseits muß an der Kammerwand und dem Sputtertarget eine intensive Kühlung, wie oben beschrieben, vorgesehen werden, was zu einem hohen Kühlwasserverbrauch führt.

Eine effiziente Kühlung des Sputtertargets (Zerstäubungskathode), das sowohl durch die Gasentladung als auch durch das heiße Substrat erwärmt wird, setzt weiterhin eine sehr aufwendige Konfektionierung (Bonden) voraus und erfordert einen beträchtlichen Zeitaufwand für den Targetwechsel, wenn das Target verbraucht ist.

Als weiterer Nachteil ist zu erwähnen, daß sich innerhalb des Substrates aufgrund seiner begrenzten Warmeleitfähigkeit eine ungleichmäßige Temperaturverteilung einstellt, so daß keine gleichmäßigen Schichteigenschaften garantiert werden können.

Aufgabe der vorliegenden Erfindung ist es daher, eine Vorrichtung und ein Verfahren zur Beschichtung eines Gegenstandes bei hoher Temperatur zur Verfügung zu stellen, bei denen das Substrat einfach, wirksam und gleichmäßig erwärmt werden kann.

Diese Aufgabe wird durch die Vorrichtung nach Anspruch 1, das Verfahren nach Anspruch 23 sowie durch Verwendungen dieser Vorrichtung und dieses Verfahrens nach den Ansprüchen 35 bis 39 gelöst. Vorteilhafte Weiterbildungen der erfindungsgemäßen Vorrichtung, des erfindungsgemäßen Verfahrens sowie der erfindungsgemäßen Verwendungen werden in den abhängigen Ansprüchen gegeben.

Erfindungsgemäß befindet sich im Inneren der Vakuumkammer eine Beschichtungskammer (Innenkammer), deren Wände aus einem hitzebeständigen Material, vorteilhafterweise mit geringer Wärmeleitfähigkeit, wie beispielsweise Graphit oder Keramik oder aus mehreren Blechen mit hohem Reflektionsvermögen im Spektralbereich der Wärmestrahlung des Targets, und damit eine sehr hohe Wärmedämmwirkung aufweisen. Das Substrat (der zu beschichtende Gegenstand) und die Sputterquelle (Zerstäubungskathode) befinden sich vollständig innerhalb dieser Beschichtungskammer. Vorteilhafterweise können die Wände der Innenkammer ganz oder auch nur abschnittsweise aus einer Anordnung aus mehreren parallelen, nicht oder nur gering im Wärmekontakt miteinander stehenden metallischen Blechen bestehen. Dies können beispielsweise mit Distanzstücken gestapelte ebene Bleche oder auch gewellte oder genoppte Bleche sein. Werden gewellte oder genoppte Bleche verwendet, so werden keine Distanzstücke benötigt, da hier die Wellung bzw. die eingeprägten Noppen für den nötigen Abstand benachbarter Bleche sorgen. Den wesentlichen Beitrag zur Wärmedämmung leistet dann hier das Vakuum bzw. das verdünnte Gas zwischen den Blechen durch seine geringe Wärmeleitfähigkeit. Die Wände der Innenkammer bestehen also aus mindestens zwei Blechen, die einander höchstens stellenweise berühren.

Weiterhin weist die Beschichtungskammer Öffnungen zum Gaseinlaß und zur Gasabsaugung auf, um das plasmaerzeugende Edelgas (beispielsweise Argon) oder weitere Gase, beispielsweise bei reaktivem Sputtern, einzuspeisen und abzusaugen.

Eine derartige erfindungsgemäße Vorrichtung benötigt keinen aufwendigen Hochtemperaturheizer, um das Substrat aufzuheizen. Denn die Betriebsbedingung der Sputterquelle können nun so gewählt werden, daß das Target eine stationäre Temperatur erreicht, die oberhalb, beispielsweise 50 K oberhalb, der gewünschten Substrattemperatur liegt. Damit strahlt das Target (Zerstäubungskathode) entweder direkt oder indirekt Wärmestrahlung auf das Substrat und heizt damit das Substrat auf. Damit liegt eine zu den herkömmlichen Hochratesputterverfahren umgekehrte Wärmeverteilung und Wärmefluß vor. Denn bei letzteren ist das Substrat wärmer als das gekühlte Target und heizt letzteres - unerwünscht - auf, während bei der vorliegender Erfindung das Target als Heizer für das Substrat verwendet wird.

Vorteilhaft hieran ist, daß folglich kein aufwendiger Hochtemperaturheizer für das Substrat benötigt wird. Weiterhin ist der Energieverbrauch der Gesamtanlage bedeutend geringer, da die Wärmeverluste zur Wand der Vakuumkammer und zur Sputterquelle sich stark verringern bzw. vollständig entfallen und außerdem die erforderliche Heizenergie vollständig aus der Abwärme der Beschichtungsquelle gewonnen wird.

Da die Beschichtungsquelle nunmehr nicht gekühlt werden muß, ist auch der Kühlmittelbedarf des Targets bedeutend geringer. Insbesondere ist für die Sputterquelle keine direkte Kühlung mehr nötig. Dies vereinfacht die Gesamtkonstruktion beträchtlich, da zum einen ein gleichmäßig guter Wärmeübergang zwischen Target und Kühlsystem technisch aufwendig ist und außerdem das auf Kathodenpotential befindliche Kühlsystem vollständig entfällt. Damit entfallen auch die elektrisch isolierten Wasserdurchführungen Vakuum/Luft sowie der Wasserwiderstand zum Potentialangleich.

Da die Zerstäubungskathode nicht eigenständig gekühlt werden muß, ist die Konfektionierung der Zerstäubungskathode auch ohne Bondplatten bzw. Bonden möglich. Damit kann auch ein Targetwechsel sehr schnell, sicher und einfach erfolgen.

Im Falle einer Gasflußsputterquelle sind außerdem an den Targetaußenseiten keine weiteren Abschirmungen erforderlich.

Vorteilhaft bei dem erfindungsgemäßen Verfahren und der erfindungsgemäßen Vorrichtung ist weiterhin, daß das Substrat sehr gleichmäßig und von der zu beschichtenden Seite her erwärmt wird und folglich auch gleichmäßige Schichteigenschaften erzielt werden können.

Vorteilhafterweise werden die Betriebsbedingungen der Sputterquelle so gewählt, daß das Target eine stationäre Temperatur erreicht, die mindestens 50 K oberhalb der gewünschten Substrattemperatur liegt. Die Sputterquelle kann dabei so gestaltet sein, daß ein ausreichend großer Anteil der Targetoberfläche seine Wärmestrahlung überwiegend direkt, z.B. im Falle einer Magnetronsputterquelle, an das Substrat gibt oder indirekt (z.B. im Falle einer Gasflußsputterquelle) über Reflexion oder Absorption an den Innenwänden der Beschichtungskammer.

Die Sputterquelle ist vorteilhafterweise konstruktiv so ausgelegt, daß bei dieser hohen Temperatur keine negativen Veränderungen auftreten, die den stabilen Betrieb der Quelle beeinträchtigen würden. Dies bedeutet insbesondere die Verwendung von ausreichend wärmebeständigen Materialien und die Berücksichtigung ihrer Wärmedehnung. Im Falle einer Magnetronsputterquelle ist für eine ausreichende Kühlung der Magnete zu sorgen.

Bei dem erfindungsgemäßen Verfahren und der erfindungsgemäßen Vorrichtung wird die Targettemperatur eingestellt entsprechend einem Gleichgewicht zwischen einem bestimmten elektrischen Leistungseintrag in die Gasentladung am Target einerseits und einer bestimmten Wärmeabfuhr aus der Beschichtungskammer andererseits, beispielsweise durch einen definierten Wärmewiderstand der Beschichtungskammerwände oder der Targethalterung oder eines optional in der Nähe des Targets angeordneten Wärmeauffangschirmes, über dessen Dimensionierung, Positionierung, Orientierung in der Beschichtungskammer und relativ zum Target bzw. Substrat, und über dessen Kühlleistung (Schirmtemperatur) eine Regelung der Wäremeabfuhr und damit der Substrattemperatur möglich ist. Die Wärme kann dann außerhalb der Beschichtungskammer an eine Kühlflüssigkeit (z.B. Wasser) oder ein Kühlgas (z.B. Luft) über einen Wärmetauschprozeß weitergegeben werden. Für den Fall, daß die Substrattemperatur bereits zu Beginn der Beschichtung die hohe Endtemperatur aufweisen muß, wird vorteilhafterweise die Sputterquelle anfangs unter Bedingungen betrieben, bei denen sie nur als Heizquelle wirkt, jedoch nicht als Beschichtungsquelle. Dies kann beispielsweise dadurch geschehen, daß der Arbeitsdruck in der Vakuumkammer soweit erhöht wird, daß die mittlere freie Weglänge der zerstäubten Partikel deutlich unter dem Abstand zwischen dem Target und dem Substrat liegt. Alternativ kann auch zwischen das Target und das Substrat in der Anfangsphase eine Schwenkblende eingeschwenkt werden, so daß die direkte gradlinige Verbindung zwischen Zerstäubungskathode und Substrat unterbrochen ist. Im Falle einer Gasflußsputterquelle kann auch der Gasfluß durch die Sputterquelle reduziert oder abgeschaltet werden.

Ein besonders stabiler Betrieb und gleichmäßige Beschichtungen können realisiert werden, wenn die Temperatur des zu beschichtenden Gegenstandes mittels eines Wärmesensors, beispielsweise eines Thermoelementes bestimmt wird, der in der Nähe des Substrates in der Innenkammer angeordnet ist. In diesem Falle kann die Substrattemperatur über den Leistungseintrag in der Sputterquelle genau gesteuert werden.

An das Substrat kann weiterhin eine Vorspannung angelegt werden, um die Schichteigenschaften der abgeschiedenen Beschichtung auf dem Substrat genau zu steuern.

Die Substrattemperatur bei dem vorliegenden Verfahren liegt im Bereich zwischen 200 und 1500 °C. Die erfindungsgemäße Vorrichtung und das erfindungsgemäße Verfahren eignen sich insbesondere für die folgenden Sputterverfahren bzw. Sputterquellen: Gasflußsputtern, Hohlkathodensputtern, Magnetronsputtern, Diodensputtern oder Triodensputtern.

Damit können Substrate mit Wärmedämmschichten, Korrosionsschichten und/oder Hochtemperaturleiterschichten, beispielsweise aus Hochschmelzmetallen und/oder Verbindungen, z.B. Oxiden, Nitriden, Carbiden oder Boriden versehen werden, beispielsweise Zirkonoxid, Ceroxid, MCrAlY-Legierungen, wobei M für ein Metall steht, oder auch YBaCuO.

Das erfindungsgemäße Verfahren und die erfindungsgemäße Vorrichtung sind insbesondere geeignet zum Beschichten von Gasturbinenschaufeln mit Wärmedämmschichten oder Korrosionsschutzschichten.

Im folgenden werden einige Beispiele für erfindungsgemäße Vorrichtungen und Verfahren gegeben.

Es zeigt:
- Figur 1: eine Gasflußsputtervorrichtung;
- Figur 2: eine Gasflußsputtervorrichtung;
- Figur 3: eine Magnetronsputtervorrichtung;
- Figur 4: den Aufbau einer Innenkammerwand;
- Figur 5: den Aufbau einer weiteren Innenkammerwand
und
- Figur 6: den Aufbau einer weiteren Innenkammerwand.

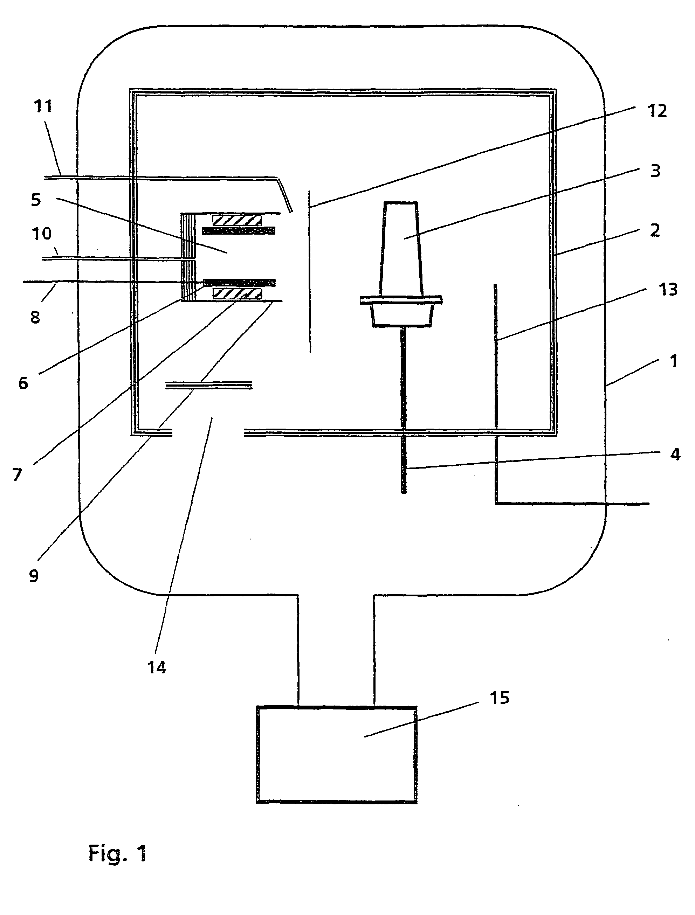

Figur 1 zeigt eine Gasflußsputtervorrichtung mit einer Vakuumkammer 1, an der eine Vakuumpumpe 15 zum Evakuieren der Vakuumkammer 1 angeordnet ist. Innerhalb der Vakuumkammer 1 befindet sich eine Beschichtungskammer 2. Diese Beschichtungskammer besitzt eine Absaugöffnung 14, um auch das Innere der Beschichtungskammer zu evakuieren. Vorzugsweise wird die Vakuumkammer von außen gekühlt, es ist jedoch auch eine Kühlung der Beschichtungskammer - ebenfalls von außen - möglich.

Innerhalb der Beschichtungskammer 2 ist eine Gasturbinenschaufel 3 als Substrat an einem Substrathalter 4 angeordnet. Gegenüber dem Substrat 3 befindet sich eine Gasflußsputterquelle 5 mit einem Target 6 (Zerstäubungskathode), einer Targethalterung 7, einem elektrischen Targetanschluß 8 sowie einer Targetdunkelraumabschirmung 9. In die Gasflußsputterquelle 5 führt eine Einspeiseleitung 10 für Argon. Weiterhin führt in die Beschichtungskammer 2 eine Einspeiseleitung 11 für Sauerstoff. Zwischen dem Target 6 und dem Substrat 3 ist weiterhin eine schwenkbare Schwenkblende 12 angeordnet, die zu Beginn des Beschichtungsprozesses, solange das Substrat noch nicht aufgewärmt ist, in den direkten Weg zwischen Target 6 und Substrat 3 eingeschwenkt werden kann und zur Beschichtung aus diesem Weg entfernt werden kann. In der Nähe der Gasturbinenschaufel 3 befindet sich ein Thermoelement 13, über das die Temperatur der Gasturbinenschaufel 3 bestimmt werden kann.

Die in Figur 1 gezeigte Vorrichtung kann nun zur Beschichtung der Gasturbinenschaufel 3 beispielsweise mit einer Zirkonoxidschicht mittels reaktivem Gasflußsputtern eingesetzt werden, wobei die Kathode nach außen abgeschirmt ist.

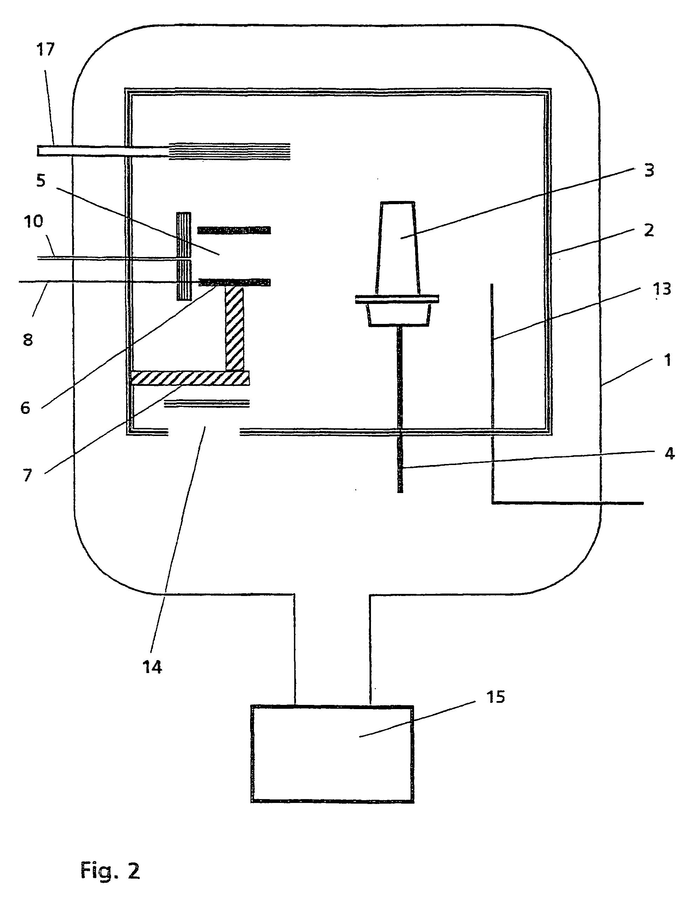

Figur 2 zeigt ein weiteres Beispiel einer Vorrichtung zur Beschichtung einer Gasturbinenschaufel, wobei in diesem Falle eine metallische Korrosionsschutzschicht mittels Gasflußsputtern abgeschieden werden kann. Dieselben Elemente wie in Figur 1 sind in Figur 2 mit denselben Bezugszeichen versehen und werden daher nicht weiter beschrieben werden.

In diesem Falle ist die Sputterkathode außen nicht abgeschirmt. In der Beschichtungskammer 2 ist zusätzlich ein Wärmeauffangschirm 17 angeordnet, über den die Temperatur in der Beschichtungskammer 2 und damit auch die Temperatur des Substrates 3 geregelt wird. Dieser Wärmeauffangschirm kann zur genauen Regelung der Temperatur des Substrates über eine Wasserkühlung gekühlt werden.

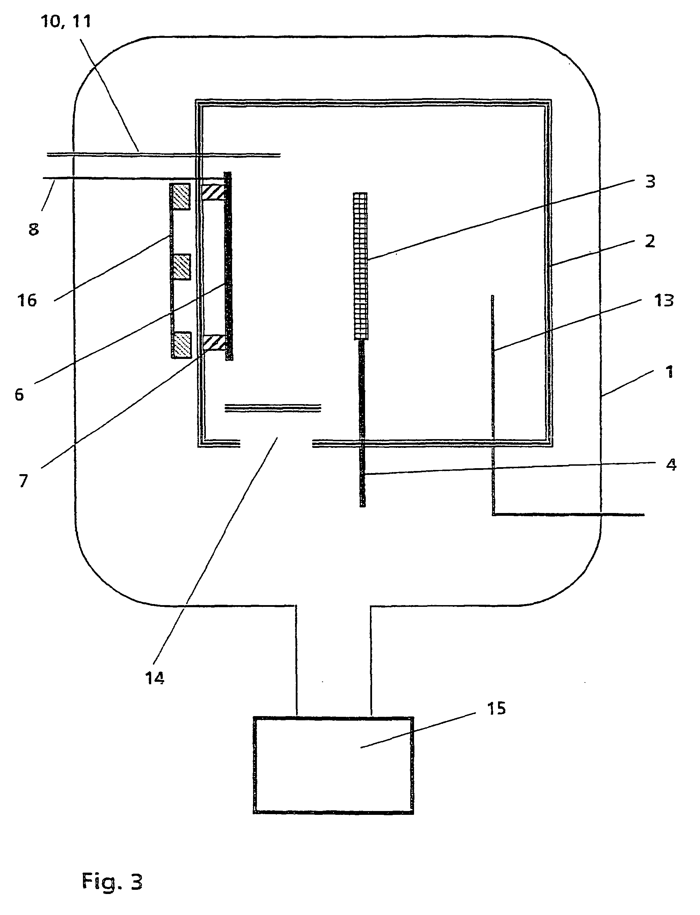

Figur 3 zeigt eine weitere erfindungsgemäße Vorrichtung zur Beschichtung von Substraten mit einer YBaCuO-Schicht mittels Magnetronsputtern. Auch in diesem Falle sind dieselben Elemente wie in Figur 1 mit denselben Bezugszeichen versehen und werden nicht weiter erläutert. Bei der Sputterquelle in Figur 3 handelt es sich jedoch im Unterschied zu den Figuren 1 und 2 nicht um eine Gasflußsputterquelle sondern um eine Magnetronsputterquelle. Dementsprechend ist die Sputterquelle aus einem Target 6, das an einer Targethalterung 7 befestigt ist, sowie einem elektrischen Targetanschluß 8 aufgebaut, wobei die Sputterquelle weiterhin einen Magnet 16 aufweist. Die Einspeisung von Argon oder Sauerstoff erfolgt über Speiseleitungen, die mit den Bezugszeichen 10 bzw. 11 bezeichnet sind.

Bei sämtlichen drei Ausführungsbeispielen der Figuren 1 bis 3 wird die Temperatur des Substrates 3 mittels eines Thermoelementes 13 bestimmt und anschließend die Temperatur des Targets 6 über den elektrischen Leistungseintrag in die Gasentladung am Target 6 so gesteuert, daß das Substrat 3 auf eine definierte Temperatur gebracht bzw. auf einer definierten gewünschten Temperatur gehalten wird.

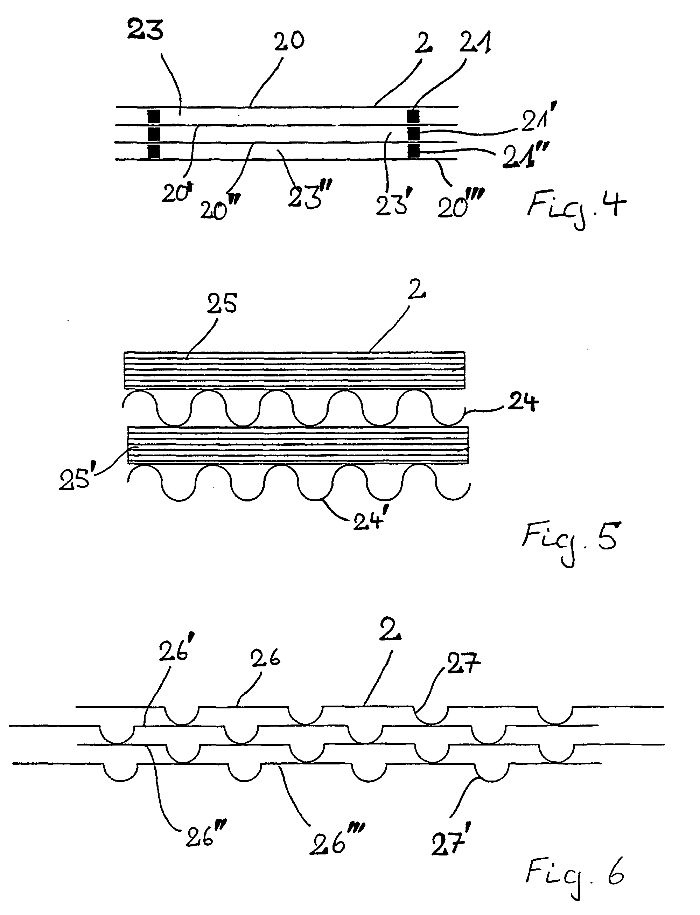

Figur 4 zeigt einen Ausschnitt aus einer Wand einer erfindungsgemäßen Innenkammer. Diese Wand besteht hier aus vier ebenen Blechen 20, 20', 20", 20''', die über Distanzstücke 21, 21', 21'' in einem vorbestimmten Abstand voneinander gehalten werden. Zwischen den ebenen Blechen 20 bis 20''' bilden sich folglich Zwischenräume 23, 23', 23", die beispielsweise mit verdünntem Gas, d.h. unter Vakuumbedingungen, gefüllt sein können. Mit einem'derartigen Aufbau der Wand der Innenkammer wird auf einfache konstruktive Weise die hohe Wärmeisolation erzielt, die für das erfindungsgemäße Verfahren und für die erfindungsgemäße Vorrichtung wesentlich ist. Die Distanzstücke 21, 21', 21'' bestehen vorzugsweise aus Keramik.

Figur 5 zeigt einen Ausschnitt aus einer weiteren erfindungsgemäßen Innenkammerwand. Diese besteht aus insgesamt vier gewellten Blechen 24, 24' sowie 25, 25', wobei die Bleche 25 und 25' um 90° gedreht zu den Blechen 24, 24' bezüglich der Wellenlängsrichtung angeordnet sind. Auch hierdurch ergeben sich zwischen den einzelnen benachbarten Blechen Zwischenräume, die mit verdünntem Gas gefüllt sein können und eine hohe Wärmeisolation bewirken.

Figur 6 zeigt eine weitere Wand einer Innenkammer 2, die aus insgesamt vier genoppten Blechen 26, 26', 26" sowie 26''' besteht. Diese Bleche weist Noppen 27, 27' auf, wobei die einzelnen genoppten Bleche derart aufeinander angeordnet sind, daß die Noppen benachbarter Bleche nicht ineinander greifen, sondern als Distanzhalter für das Blech zum benachbarten Blech dienen.

Im folgenden werden einige Ausführungsbeispiele des erfindungsgemäßen Verfahrens gegeben.

In einem ersten Beispiel wird eine Vorrichtung wie in den Figuren 1 oder 2 gezeigt, zum Beschichten von Gasturbinenschaufeln bei 1100 °C mit yttriumstabilisiertem Zirkonoxid verwendet. Hierzu wird zuerst eine zu beschichtende Gasturbinenschaufel auf 400 °C vorgeheizt und anschließend in die geöffnete Vakuumkammer und die geöffnete Beschichtungskammer eingesetzt. Nach Schließen der Beschichtungskammer und der Vakuumkammer werden diese evakuiert und anschließend die Gasflußsputterquelle ausschließlich als Heizer betrieben. Dies wird erreicht, indem kein Arbeitsgas durch die Gasflußsputterquelle geleitet wird. Es bildet sich nun zwar ein Plasma aus, es erfolgt jedoch kein Materialtransport von abgestäubtem Kathodenmaterial mehr zum Substrat, da die Quelle nicht von einem Gasstrom durchströmt wird. Etwaig abgestäubtes Material scheidet sich folglich wieder auf der Kathodenoberfläche ab, ohne das Substrat zu erreichen.

Dennoch wird zum Aufheizen des Targets Argon außerhalb der Gasflußsputterquelle in die Innenkammer eingeleitet, so daß sich ein Plasma zum Aufheizen des Targets ausbildet. Zur Einsparung von Argon kann beim Aufheizen dabei der Gasfluß stark reduziert werden, sofern gleichzeitig das Saugvermögen der Vakuumpumpe entsprechend vermindert wird (z.B. durch ein Drosselventil), damit sich trotzdem ein ausreichend hoher Druck zur Erzeugung eines Plasmas einstellt. Zusätzlich kann optimal eine Abschirmung (Schirm) in die direkte Linie zwischen Target und Substrat eingeschwenkt werden.

Nach Erreichen der Beschichtungstemperatur der Gasturbinenschaufel wird der Betrieb der Sputterquelle auf einen Betrieb als Beschichtungsquelle umgestellt. Hierzu wird nunmehr Argon nicht mehr außerhalb der Gasflußsputterquelle in die Innenkammer eingeleitet sondern der Argongasfluß unmittelbar durch die Sputterquelle hindurch geleitet und gegebenenfalls der Schwenkschirm aus der direkten Linie zwischen Target und Substrat entfernt. Weiterhin wird Sauerstoff separat in die Beschichtungskammer in der Nähe der Sputterquelle und des Substrates eingespeist, um ein reaktives Gasflußsputtern auszulösen.

Während der Beschichtung wird ständig die Temperatur der Gasturbinenschaufel über ein Thermoelement gemessen und die Temperatur der Gasturbinenschaufel über die Sputterquellenleistung auf ca. 1100 °C eingeregelt.

Nach Erreichen der erforderlichen Schichtdicke wird die Sputterquelle abgeschaltet und eine hohe Abkühlgeschwindigkeit eingestellt, indem ein Gasdruck von 1 bar in Verbindung mit einem hohem Gasdurchsatz in der Beschichtungskammer eingestellt wird.

Nach Abkühlen der Gasturbinenschaufel, die nunmehr eine Schicht aus yttriumstabilisiertem Zirkonoxid aufweist, wird diese aus der Vakuumkammer und der Beschichtungskammer entnommen und die Kammern werden anschließend wieder geschlossen.

In einem weiteren Verfahrensbeispiel, das mit einer Magnetronsputterquelle gemäß Figur 3 durchgeführt werden kann, wird ein zu beschichtendes Bauteil als Substrat, das Raumtemperatur aufweist, in die geöffnete Vakuumkammer und die geöffnete Beschichtungskammer eingesetzt und anschließend werden beide Kammern geschlossen. Daraufhin werden die beiden Kammern evakuiert und die Magnetronsputterquelle ausschließlich als Heizer betrieben. Hierzu wird Arbeitsgas unter hohem Druck, beispielsweise 0,1 mbar, in die Vakuumkammer eingeleitet, so daß die abgesputterten Partikel aufgrund ihrer geringen freien Weglänge das zu beschichtende Substrat nicht erreichen.

Nach Erreichen der Beschichtungstemperatur für das Bauteil wird die Sputterquelle als Beschichtungsquelle betrieben. Dazu wird der Druck in der Vakuumkammer und der Beschichtungskammer abgesenkt. Auch hier wird wiederum die Temperatur des Bauteils über ein Thermoelement permanent gemessen und die Temperatur des Bauteils über die Sputterquellenleistung auf ca. 900 °C eingeregelt. Mit diesem Verfahren lassen sich CoCrAlY-Schichten auf Gasturbinenschaufeln als Bauteil mittels Magnetronsputtern aufbringen.

Nach Erreichen der erforderlichen Schichtdicke der CoCrAlY-Schichten wird die Sputterquelle abgeschaltet und die Abkühlgeschwindigkeit durch Einstellen eines Gasdruckes von 0,5 bar für ein moderates Abkühlen eingeregelt.

Nach Abkühlen der Gasturbinenschaufel wird diese nach Öffnen der Vakuumkammer und Beschichtungskammer aus den beiden Kammern entnommen und anschließend werden beide Kammern geschlossen.

In einem weiteren Verfahrensbeispiel werden planare Saphirsubstrate bei 700 °C mittels teilreaktivem Hohlkathodensputtern mit einer Beschichtung aus YBaCuO versehen.

Zuerst wird das Saphirsubstrat, das Raumtemperatur aufweist, in die geöffnete Vakuumkammer und die geöffnete Beschichtungskammer eingesetzt, die beiden Kammern werden geschlossen und evakuiert. Danach wird die Hohlkathoden-Sputterquelle ausschließlich als Heizer betrieben. Hierzu wird eine Schwenkblende zwischen die Hohlkathoden-Sputterquelle und das planare Saphirsubstrat eingefügt, so daß die abgestäubten Partikel der Sputterquelle sich nicht unmittelbar auf dem Substrat niederschlagen. Das Substrat wird jedoch indirekt über die Wände der Beschichtungskammer dennoch aufgeheizt.

Nach Erreichen der gewünschten Beschichtungstemperatur von 700 °C wird die Schwenkblende zwischen der Sputterquelle und dem Substrat entfernt, so daß nunmehr die Sputterquelle als Beschichtungsquelle betrieben wird. Wiederum wird die Temperatur des Substrates über ein Thermoelement gemessen und über die Sputterquellenleistung eingeregelt.
Nach Erreichen der erforderlichen Schichtdicke der YBaCuO-Schicht wird die Sputterquelle abgeschaltet. Der Sauerstoff-Partialdruck wird jedoch aufrechterhalten und es wird eine geringe Abkühlgeschwindigkeit eingestellt, indem der Gasdruck bei 1 mbar gehalten wird.

Nachdem das Substrat abgekühlt ist, wird es aus der geöffneten Vakuumkammer und der geöffneten Beschichtungskammer entnommen und beide Kammern werden wiederum geschlossen.

## Patentansprüche

1. Vorrichtung zur Beschichtung eines Gegenstandes (3) bei hoher Temperatur mittels Kathodenzerstäubung mit
einer Vakuumkammer (1) und einer Sputterquelle (5),
wobei die Sputterquelle eine Zerstäubungskathode (6) aufweist,
innerhalb der Vakuumkammer eine Innenkammer (2) aus einem hitzebeständigen Material angeordnet ist,
die die Zerstäubungskathode (6) und den zu beschichtenden Gegenstand (3) in geringem Abstand vollständig umschließt und
die mindestens eine Öffnung (10, 11) zum Einlaß eines Gases und mindestens eine Öffnung (14) zum Auslaß eines Gases aufweist,
**dadurch gekennzeichnet,**
**daß** das Material der Innenkammer (2) ein Material mit geringer Wärmeleitfähigkeit enthält.

2. Vorrichtung nach einem der vorhergehenden Ansprüche, **dadurch gekennzeichnet, daß** das Material der Innenkammer (2) Graphit und/oder einen keramischen Werkstoff enthält.

3. Vorrichtung nach einem der vorhergehenden Ansprüche, **dadurch gekennzeichnet, daß** das Material der Innenkammer (2) ein hohes Reflexionsvermögen für Wärmestrahlung aufweist.

4. Vorrichtung nach einem der vorhergehenden Ansprüche, **dadurch gekennzeichnet, daß** mindestens eine Wand der Innenkammer zumindest bereichsweise mindestens zwei Metalllagen aufweist, die parallel zueinander und mit Zwischenräumen zwischen den einzelnen Metalllagen angeordnet sind.

5. Vorrichtung nach dem vorhergehenden Anspruch, **dadurch gekennzeichnet, daß** mindestens eine Metalllage ein ebenes Blech ist.

6. Vorrichtung nach einem der beiden vorhergehenden Ansprüche, **dadurch gekennzeichnet, daß** mindestens eine Metalllage ein gewelltes Blech ist oder eine Noppenstruktur aufweist.

7. Vorrichtung nach einem der drei vorhergehenden Ansprüche, **dadurch gekennzeichnet, daß** zwischen zwei Metalllagen Abstandhalter angeordnet sind.

8. Vorrichtung nach einem der Ansprüche 4 bis 7, dadurch gekennzeichent, daß die Zwischenräume mit einem verdünnten Gas gefüllt sind oder ein Vakuum aufweisen.

9. Vorrichtung nach einem der vorhergehenden Ansprüche, **dadurch gekennzeichnet, daß** die Zerstäubungskathode (6) und der Gegenstand (3) derart angeordnet ist, daß die Oberfläche der Zerstäubungskathode (6) ihre Wärmeabstrahlung direkt auf den Gegenstand (3) strahlt.

10. Vorrichtung nach einem der Ansprüche 1 bis 8, **dadurch gekennzeichnet, daß** die Zerstäubungskathode (6), der Gegenstand (3) und die Wände der Innenkammer (2) derart angeordnet ist, daß die Oberfläche der Zerstäubungskathode (6) ihre Wärmeabstrahlung indirekt über die Wände der Innenkammer (2) auf den Gegenstand (3) strahlt.

11. Vorrichtung nach einem der vorhergehenden Ansprüche, **dadurch gekennzeichnet, daß** die Sputterquelle (5) aus hitzebeständigen Materialien besteht.

12. Vorrichtung nach einem der vorhergehenden Ansprüche, **dadurch gekennzeichnet, daß** bei oder an dem Gegenstand (3) ein Temperatursensor (13) angeordnet ist.

13. Vorrichtung nach dem vorhergehenden Anspruch, **dadurch gekennzeichnet, daß** eine Steuervorrichtung vorgesehen ist, die den elektrischen Leistungseintrag in die Gasentladung an der Zerstäubungskathode (6) in Abhängigkeit von dem Meßsignal des Temperatursensors (13) steuert.

14. Vorrichtung nach einem der beiden vorhergehenden Ansprüche, **dadurch gekennzeichnet, daß** eine Steuervorrichtung vorgesehen ist, die den elektrischen Leistungseintrag in die Gasentladung an der Zerstäubungskathode (6) in Abhängigkeit von dem Meßsignals des Temperatursensors (13) derart steuert, daß die Temperatur des Gegenstandes (3) konstant gehalten wird.

15. Vorrichtung nach einem der vorhergehenden Ansprüche, **dadurch gekennzeichnet, daß** zwischen Zerstäubungskathode (6) und Gegenstand (3) eine bewegbare Blende (12) angeordnet ist.

16. Vorrichtung nach dem vorhergehenden Anspruch, **dadurch gekennzeichnet, daß** die Blende (12) eine Schwenkblende ist.

17. Vorrichtung nach einem der vorhergehenden Ansprüche, **dadurch gekennzeichnet, daß** in der Innenkammer (2) ein Wärmeauffangschirm (17) angeordnet ist.

18. Vorrichtung nach einem der vorhergehenden Ansprüche, **dadurch gekennzeichnet, daß** die Wände der Innenkammer (2) einen bestimmten Wärmewiderstand aufweisen.

19. Vorrichtung nach einem der vorhergehenden Ansprüche, **dadurch gekennzeichnet, daß** die Sputterquelle (5) eine Magnetronsputterquelle ist.

20. Vorrichtung nach dem vorhergehenden Anspruch, **dadurch gekennzeichnet, daß** der Magnet (16) der Magnetronsputterquelle (5) kühlbar ist.

21. Vorrichtung nach einem der Ansprüche 1 bis 14, **dadurch gekennzeichnet, daß** die Sputterquelle (5) eine Gasflußsputterquelle, eine Hohlkathodensputterquelle, eine Diodensputterquelle und/oder eine Triodensputterquelle ist.

22. Verfahren zum Beschichten eines Gegenstandes (3) bei einer gewünschten, erhöhten Temperatur des Gegenstandes (3) durch Zerstäubung einer Zerstäubungskathode (6) in einer Vakuumkammer (1), **dadurch gekennzeichnet**, d a ß
die Zerstäubungskathode (6) und der Gegenstand (3) in einer die Zerstäubungskathode (6) und den Gegenstand (3) vollständig umschließenden, in der Vakuumkammer (1) angeordneten Innenkammer (2) aus hitzebeständigem Material derart angeordnet wird, daß von der Zerstäubungskathode (6) emittierte Wärmestrahlung zu einem großen Teil direkt oder indirekt über die Wände der Innenkammer (2) auf den Gegenstand (3) aufgestrahlt wird und die Zerstäubungskathode (6) derart betrieben wird, daß sie eine Temperatur oberhalb der gewünschten Temperatur erreicht.

23. Verfahren nach dem vorhergehenden Anspruch, **dadurch gekennzeichnet, daß** die Zerstäubungskathode (6) derart betrieben wird, daß sie eine Temperatur mindestens 50 °C über der gewünschten Temperatur aufweist.

24. Verfahren nach einem der beiden vorhergehenden Ansprüche, **dadurch gekennzeichnet, daß** als gewünschte Temperatur eine Temperatur zwischen 200 °C und 1500 °C erreicht wird.

25. Verfahren nach einem der Ansprüche 22 bis 24, **dadurch gekennzeichnet, daß** die Temperatur des Gegenstandes (3) erfaßt und bestimmt wird.

26. Verfahren nach dem vorhergehenden Anspruch, **dadurch gekennzeichnet, daß** der elektrische Leistungseintrag in die Gasentladung an der Zerstäubungskathode (6) in Abhängigkeit von der bestimmten Temperatur geregelt wird.

27. Verfahren nach einem der Ansprüche 18 bis 22, **dadurch gekennzeichnet, daß** die Zerstäubungskathode (6) zuerst unter Bedingungen betrieben wird, bei denen sie nur als Heizquelle nicht jedoch als Beschichtungsquelle wirkt und nach Aufheizen des Gegenstandes (3) die Zerstäubungskathode (6) zum Beschichten betrieben wird.

28. Verfahren nach dem vorhergehenden Anspruch, **dadurch gekennzeichnet, daß** zum Betreiben der Zerstäubungskathode (6) nur als Heizquelle und nicht als Beschichtungsquelle der Arbeitsgasdruck in der Vakuumkammer (1) derart eingestellt wird, daß die mittlere freie Weglänge der Gasmoleküle bzw. Atome deutlich geringer ist als der Abstand zwischen der Zerstäubungskathode (6) und dem Gegenstand (3).

29. Verfahren nach einem der beiden vorhergehenden Ansprüche, **dadurch gekennzeichnet, daß** zum Betreiben der Zerstäubungskathode (6) nur als Heizquelle und nicht als Beschichtungsquelle eine Schwenkblende (12) zwischen Zerstäubungskathode (6) und Gegenstand (3) eingebracht wird.

30. Verfahren nach einem der drei vorhergehenden Ansprüche, **dadurch gekennzeichnet, daß** zum Betreiben der Zerstäubungskathode (6) nur als Heizquelle und nicht als Beschichtungsquelle der Gasfluß durch die Vakuumkammer (1) reduziert oder abgeschaltet wird.

31. Verfahren nach einem der Ansprüche 22 bis 30, **dadurch gekennzeichnet, daß** der Gegenstand (3) zuerst außerhalb der Vakuumkammer (1) vorgewärmt und anschließend zur Beschichtung in die Vakuumkammer (1) eingebracht wird.

32. Verfahren nach einem der Ansprüche 22 bis 32, **dadurch gekennzeichnet, daß** während der Beschichtung der Gegenstand (3) unter eine Vorspannung gesetzt wird.

33. Verfahren nach dem vorhergehenden Anspruch, **dadurch gekennzeichnet, daß** die Vorspannung in Abhängigkeit von den gewünschten Eigenschaften der Beschichtung gesteuert wird.

34. Verwendung einer Vorrichtung und/oder eines Verfahrens nach einem der vorhergehenden Ansprüche zum Beschichten von Gegenständen (3) mit Wärmedämmschichten, Korrosionsschutzschichten und/oder Hochtemperatursupraleiterschichten.

35. Verwendung einer Vorrichtung und/oder eines Verfahrens nach einem der Ansprüche 1 bis 33 zum Beschichten von Gegenständen (3) mit hochschmelzenden Metallen und/oder Verbindungen.

36. Verwendung einer Vorrichtung und/oder eines Verfahrens nach einem der Ansprüche 1 bis 33 zum Beschichten von Gegenständen (3) mit Oxiden, Nitriden, Carbiden, Boriden.

37. Verwendung einer Vorrichtung und/oder eines Verfahrens nach einem der Ansprüche 1 bis 33 zum Beschichten von Gegenständen (3) mit Zirkonoxid, Ceroxid, MCrAlY-Legierungen, wobei M ein Metall ist, und/oder YBaCuO.

38. Verwendung nach einem der Ansprüche 34 bis 37 zum Beschichten von Gasturbinenschaufeln.

## Claims

1. Device for coating an object (3) at high temperature by means of cathode sputtering, comprising
a vacuum chamber (1) and a sputter source (5), and
the sputter source comprises a sputter cathode (6), and
inside the vacuum chamber is arranged an inner chamber (2) of a heat-resistant material, which
fully encases the sputter cathode (6) and the object to be coated (3) at close distance, and
includes at least one opening (10, 11) as gas inlet and at least one opening (14) as gas outlet
**characterised in that**
the material of the inner chamber (2) contains a material of low heat conductivity.

2. Device according to the above claim, **characterised in that** the material of the inner chamber (2) includes graphite and/or a ceramic material.

3. Device according to one of the above claims, **characterised in that** the material of the inner chamber (2) includes a high reflection property for heat radiation.

4. Device according to one of the above claims, **characterised in that** at least one wall of the inner chamber comprises at least in some areas at least two metal layers arranged in parallel and with intermediate spaces between the individual metal layers.

5. Device according to the above claim, **characterised in that** at least one metal layer is a flat metal sheet.

6. Device according to one of the two previous claims, **characterised in that** at least one metal layer is either a corrugated metal sheet or comprises a point structure.

7. Device according to one of the three previous claims, **characterised in that** spacers are arranged between two metal layers.

8. Device according to one of Claims 4 to 7, **characterised in that** the intermediate spaces are filled with a diluted gas or vacuumised.

9. Device according to one of the above claims, **characterised in that** the sputter cathode (6) and the object (3) are arranged in such a manner that the surface of the sputter cathode (6) beams its heat radiation directly onto the object (3).

10. Device according to one of Claims 1 to 8, **characterised in that** the sputter cathode (6), the object (3) and the walls of the inner chamber (2) are arranged in such a manner that the surface of the sputter cathode (6) beams its heat radiation indirectly via the walls of the inner chamber (2) onto the object (3).

11. Device according to one of the above claims, **characterised in that** the sputter source (5) is composed of heat-resistant materials.

12. Device according to one of the above claims, **characterised in that** a temperature sensor (13) is arranged at or on the object (3).

13. Device according to the above claim, **characterised in that** a control device is provided which controls the electric power input into the gas discharge at sputter cathode (6) in dependence of the measuring signal of the temperature sensor (13).

14. Device according to one of the two previous claims, **characterised in that** a control device is provided which controls the electric power input into the gas discharge at the sputter cathode (6) in dependence of the measuring signal of the temperature sensor (13) in such a manner that the temperature of the object (3) is kept constant.

15. Device according to one of the above claims, **characterised in that** between sputter cathode (6) and the object (3) is arranged a movable diaphragm (12).

16. Device according to the above claim, **characterised in that** the diaphragm (12) is a pivotal diaphragm.

17. Device according to one of the above claims, **characterised in that** a heat-trap dish (17) is arranged in the inner chamber (2).

18. Device according to one of the above claims, **characterised in that** the walls of the inner chamber (2) offer a specified heat resistance.

19. Device according to one of the above claims, **characterised in that** the sputter source (5) is a magnetron sputter source.

20. Device according to the above claim, **characterised in that** the magnet (16) of the magnetron sputter source (5) is coolable.

21. Device according to one of Claims 1 to 14, **characterised in that** the sputter source (5) is a gas-flow sputter source, a cavity cathode sputter source, a diode sputter source and/or a triode sputter source.

22. Method of coating an object (3) at a desired increased temperature of the object (3) by sputtering of a sputter cathode (6) in a vacuum chamber (1), **characterised in that** the sputter cathode (6) and the object (3) are arranged in an inside chamber (2) of heat-resistant material which is arranged in the vacuum chamber (1) and fully encases the sputter cathode (6) and the object (3) in such a manner that heat radiation emitted by the sputter cathode (6) is to a large proportion directly or indirectly beamed via the walls of the inside chamber (2) at the object (3), and the sputter cathode (6) is operated in such a manner that it arrives at a temperature above a desired temperature.

23. Method according to the above claim, **characterised in that** the sputter cathode (6) is operated in such a manner that it comprises a temperature of at least 50°C above the desired temperature.

24. Method according to one of the two above claims, **characterised in that** a desired temperature between 200 and 1,500 °C is arrived at.

25. Method according to one of Claims 22 to 24, **characterised in that** the temperature of the object (3) is determined and set.

26. Method according to the above claim, **characterised in that** the electric power input into the gas discharge at the sputter cathode (6) is regulated in dependence of the set speed.

27. Method according to one of Claims 18 to 22, **characterised in that** the sputter cathode (6) is initially operated under conditions in which it acts only as heating source but not as coating source, and after heating up the object (3) the sputter cathode (6) is operated for coating purposes.

28. Method according to the above claim, **characterised in that** for operating the sputter cathode (6) as heating source only and not as coating source the working gas pressure in the vacuum chamber (1) is set so that the mean free path length of the gas molecules or atoms is clearly less than the gap between the sputter cathode (6) and the object (3).

29. Method according to one of the two above claims, **characterised in that** for operating the sputter cathode (6) as heating source only and not as a coating source, a pivotal diaphragm (12) is placed between sputter cathode (6) and the object (3).

30. Method according to one of the three above claims, **characterised in that** for the purpose of operating the sputter cathode (6) as heating source only and not as coating source, the gas flow through the vacuum chamber (1) is reduced or switched off.

31. Method according to one of Claims 22 to 30, **characterised in that** the object (3) is initially preheated outside the vacuum chamber (1) and subsequently entered into the vacuum chamber (1) for the purpose of coating.

32. Method according to one of Claims 22 to 31, **characterised in that** the object (3) is pretensioned during coating.

33. Method according to the above claim, **characterised in that** the pretension is controlled in dependence of desired properties of the coating.

34. Use of a device and/or method according to one of the above claims for coating objects (3) with heat absorbing layers, anticorrosive layers and/or high-temperature supra-conductor layers.

35. Use of a device and/or a method according to one of Claims 1 to 33 for coating objects (3) with high-melting metals and/or composites.

36. Use of a device and/or a method according to one of Claims 1 to 33 for coating objects (3) with oxides, nitrides, carbides, borides.

37. Use of a device and/or a method according to one of Claims 1 to 33 for coating objects (3) with zircon oxide, ceroxide, MCrAlY alloys, where M is a metal, and/or YBaCuO.

38. Use according to one of Claims 34 to 37 for coating of gas turbine blades.

## Revendications

1. Dispositif pour recouvrir un objet (3) à une température élevée au moyen d'une pulvérisation cathodique, comportant
une chambre à vide (1) et une source de pulvérisation (5),
la source de pulvérisation comportant une cathode de pulvérisation (6),
une chambre intérieure (2) formée d'un matériau réfractaire étant disposée à l'intérieur de la chambre à vide,
qui entoure complètement, à faible distance, la cathode de pulvérisation (6) et l'objet (3) à recouvrir, et
qui comporte au moins une ouverture (10, 11) pour l'introduction d'un gaz et au moins une ouverture (14) pour l'évacuation d'un gaz,
**caractérisé en ce**
**que** le matériau de la chambre intérieure (2) contient un matériau possédant une conductibilité thermique faible.

2. Dispositif selon la revendication 1, **caractérisé en ce que** le matériau de la chambre intérieure (2) contient du graphite et/ou un matériau céramique.

3. Dispositif selon l'une des revendications précédentes, **caractérisé en ce que** le matériau de la chambre intérieure (2) possède un pouvoir réfléchissant élevé pour le rayonnement thermique.

4. Dispositif selon l'une des revendications précédentes, **caractérisé en ce qu'**au moins une paroi de la chambre intérieure comporte, au moins par endroits, au moins deux couches métalliques, qui sont disposées parallèlement l'une à l'autre, avec des espaces intercalaires entre les différentes couches métalliques.

5. Dispositif selon la revendication précédente, **caractérisé en ce qu'**au moins une couche métallique est une tôle plane.

6. Dispositif selon l'une des deux revendications précédentes, **caractérisé en ce qu'**au moins une couche métallique est une tôle ondulée ou possède une structure pourvue de bossages.

7. Dispositif selon l'une des trois revendications précédentes, **caractérisé en ce que** des entretoises sont disposées entre deux couches métalliques.

8. Dispositif selon l'une des revendications 4 à 7, **caractérisé en ce que** les espaces intercalaires sont remplis par un gaz dilué ou qu'un vide est présent dans les espaces intercalaires.

9. Dispositif selon l'une des revendications précédentes, **caractérisé en ce que** la cathode de pulvérisation (6) et l'objet (3) sont disposés de telle sorte que la surface de la cathode pulvérisation (6) émet son rayonnement thermique directement sur l'objet (3).

10. Dispositif selon l'une des revendications 1 à 8, **caractérisé en ce que** la cathode de pulvérisation (6), l'objet (3) et la paroi de la chambre intérieure (2) sont disposés de telle sorte que la surface de la cathode de pulvérisation (6) envoie son rayonnement thermique sur l'objet (3) indirectement par l'intermédiaire de la paroi de la chambre intérieure (2).

11. Dispositif selon l'une des revendications précédentes, **caractérisé en ce que** la source de pulvérisation (5) se compose de matériaux réfractaires.

12. Dispositif selon l'une des revendications précédentes, **caractérisé en ce qu'**un capteur de température (13) est disposé à côté de l'objet (3) ou sur ce dernier.

13. Dispositif selon l'une des revendications précédentes, **caractérisé en ce qu'**il est prévu un dispositif de commande, qui commande l'entrée de puissance électrique dans la décharge dans le gaz au niveau de la cathode de pulvérisation (6) en fonction du signal de mesure du capteur de température (13).

14. Dispositif selon l'une des deux revendications précédentes, **caractérisé en ce qu'**il est prévu un dispositif de commande qui commande l'entrée de puissance électrique dans la décharge dans le gaz au niveau de la cathode de pulvérisation (6) en fonction du signal de mesure du capteur de température (13), de telle sorte que la température de l'objet (3) est maintenue constante.

15. Dispositif selon l'une des revendications précédentes, **caractérisé en ce qu'**un diaphragme mobile (12) est disposé entre la cathode de pulvérisation (6) et l'objet (3).

16. Dispositif selon la revendication précédente, **caractérisé en ce que** le diaphragme (12) est un diaphragme pivotant.

17. Dispositif selon l'une des revendications précédentes, **caractérisé en ce qu'**un écran de retenue thermique (17) est disposé dans la chambre intérieure (2).

18. Dispositif selon l'une des revendications précédentes, **caractérisé en ce que** les parois de la chambre intérieure (2) possèdent une résistance thermique déterminée.

19. Dispositif selon l'une des revendications précédentes, **caractérisé en ce que** la source de pulvérisation (5) est une source de pulvérisation à magnétron.

20. Dispositif selon l'une des revendications précédentes, **caractérisé en ce que** l'aimant (16) de la source de pulvérisation à magnétron (5) peut être refroidi.

21. Dispositif selon l'une des revendications 1 à 14, **caractérisé en ce que** la source de pulvérisation (5) est une source de pulvérisation à flux de gaz, une source de pulvérisation à cathode creuse, une source de pulvérisation à diode et/ou une source de pulvérisation à triode.

22. Procédé pour recouvrir un objet (3), dans le cas d'une température accrue désirée de l'objet (3), par pulvérisation d'une cathode de pulvérisation (6) dans une chambre à vide (1), **caractérisé en ce que** la cathode de pulvérisation (6) et l'objet (3) sont disposés dans une chambre intérieure (2) réalisée en un matériau réfractaire, qui entoure complètement la cathode de pulvérisation (6) et l'objet (3) et est disposée dans la chambre à vide (1), de telle sorte que le rayonnement thermique émis par la cathode de pulvérisation (6) est envoyé pour une grande part directement ou indirectement sur l'objet (3) au moyen des parois de la chambre intérieure (2), et la cathode de pulvérisation (6) fonctionne de telle sorte qu'elle atteint une température supérieure à la température désirée.

23. Procédé selon la revendication précédente, **caractérisé en ce que** la cathode de pulvérisation (6) fonctionne de telle sorte qu'elle possède une température qui est supérieure d'au moins 50°C à la température désirée.

24. Procédé selon l'une des deux revendications précédentes, **caractérisé en ce qu'**une température comprise entre 200° et 1500°C est atteinte en tant que température désirée.

25. Procédé selon l'une des revendications 22 à 24, **caractérisé en ce que** la température de l'objet (3) est détectée et déterminée.

26. Procédé selon la revendication précédente, **caractérisé en ce que** l'entrée de puissance électrique dans la décharge dans le gaz au niveau de la cathode de pulvérisation (6) est réglée en fonction de la température déterminée.

27. Procédé selon l'une des revendications 18 à 22, **caractérisé en ce que** la cathode de pulvérisation (6) fonctionne tout d'abord dans des conditions, dans lesquelles elle agit uniquement en tant que source de chauffage, mais pas en tant que source de revêtement et la cathode de pulvérisation (6) fonctionne pour l'application du revêtement, après le chauffage de l'objet (3).

28. Procédé selon la revendication précédente, **caractérisé en ce que** pour faire fonctionner la cathode de pulvérisation (6) uniquement en tant que source de chauffage et pas en tant que source de revêtement on règle la pression du gaz de travail dans la chambre à vide (1) de telle sorte que le libre parcours moyen des molécules ou des atomes de gaz est nettement inférieure à la distance entre la cathode de pulvérisation (6) et l'objet (3).

29. Procédé selon l'une des deux revendications précédentes, **caractérisé en ce que** pour faire fonctionner la cathode de pulvérisation (6) uniquement en tant que source de chaleur et non en tant que source de revêtement, un diaphragme pivotant (12) est monté entre la cathode de pulvérisation (6) et l'objet (3).

30. Procédé selon l'une des trois revendications précédentes, **caractérisé en ce que** pour faire fonctionner la cathode de pulvérisation (6) uniquement en tant que source de chauffage et non en tant que source de revêtement, on réduit ou on interrompt le flux de gaz traversant la chambre à vide (1).

31. Procédé selon l'une des revendications 22 à 30, **caractérisé en ce qu'**on réalise tout d'abord un préchauffage de l'objet (3) à l'extérieur de la chambre à vide (1) et qu'on le place ensuite, pour son recouvrement, dans la chambre à vide (1).

32. Procédé selon l'une des revendications 22 à 31, **caractérisé en ce que** pendant l'opération de revêtement, on soumet l'objet (3) à une tension de polarisation.

33. Procédé selon la revendication précédente, **caractérisé en ce qu'**on règle la tension de polarisation en fonction des caractéristiques désirées du revêtement.

34. Utilisation d'un dispositif et/ou d'un procédé selon l'une des revendications précédentes, pour recouvrir des objets (3) avec des couches de calorifugeage, des couches anticorrosion et/ou des couches supraconductrices à haute température.

35. Utilisation d'un dispositif et/ou d'un procédé selon l'une des revendications 1 à 33, pour recouvrir des objets (3) comportant des métaux et/ou des liaisons hautement fusibles.

36. Utilisation d'un dispositif et/ou d'un procédé selon l'une des revendications 1 à 33, pour recouvrir des objets (3) comportant des oxydes, des nitrures, des carbures, des borures.

37. Utilisation d'un dispositif et/ou d'un procédé selon l'une des revendications 1 à 33, pour recouvrir des objets (3) comportant de l'oxyde de zirconium, de l'oxyde de cérium, des alliages MCrAlY, M étant un métal, et/ou du YBaCuO.

38. Utilisation selon l'une des revendications 34 à 37, pour recouvrir des aubes de turbines à gaz.
